Europäisches Patentamt

European Patent Office

Office européen des brevets

(19)

(11) Veröffentlichungsnummer: **0 024 035**
A1

(12) **EUROPÄISCHE PATENTANMELDUNG**

(21) Anmeldenummer: 80104636.8

(22) Anmeldetag: 06.08.80

(51) Int. Cl.³: **H 01 L 27/20**
G 01 L 1/22

(30) Priorität: 14.08.79 DE 2932956

(43) Veröffentlichungstag der Anmeldung:
18.02.81 Patentblatt 81/7

(84) Benannte Vertragsstaaten:
FR GB IT

(71) Anmelder: SIEMENS AKTIENGESELLSCHAFT Berlin
und München
Postfach 22 02 61
D-8000 München 22(DE)

(72) Erfinder: Roloff, Herbert F., Dr. Dipl.-Phys.
Akademiestrasse 21
D-8000 München 40(DE)

(54) **Piezoresistive Sonde.**

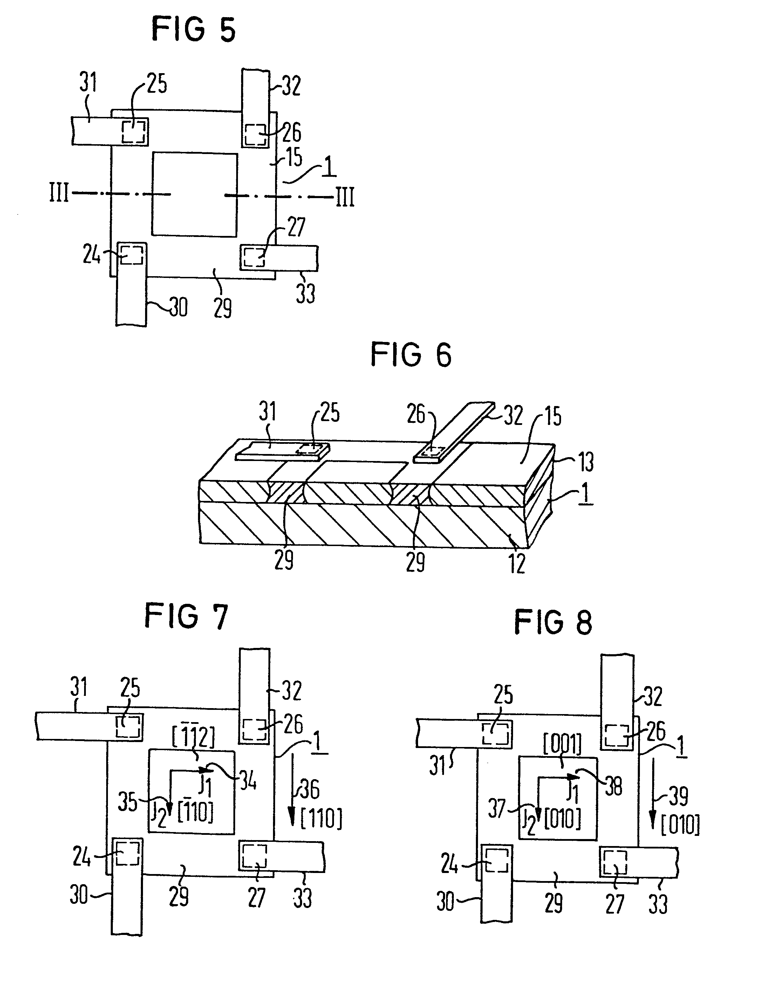

(57) Der Erfindung leigt die Aufgabe zugrunde, eine piezoresistive Sonde zur Messung von mechanischen Spannungen
anzugeben, die möglichst unempfindlich ist gegen äußere
Störeinflüsse und bei der sich die Temperaturabhängigkeit
geeignet kompensieren läßt. Erfindungsgemäß wird die piezoresistive Sonde (1) in einer Integrierten Schaltung in ein
Halbleiterchip so angebracht, daß im gleichen Halbleiterchip
ein zugehöriger Verstärker integriert ist. Anwendung bei
Drucksensoren und Beschleunigungssensoren sowie Kraftsensoren in Form von Integrierten Schaltungen (Fig. 5).

**FIG 5**

SIEMENS AKTIENGESELLSCHAFT          Unser Zeichen
Berlin und München                  VPA

79 P 1 1 4 0 EUR

## Piezoresistive Sonde

Die Erfindung betrifft eine piezoresistive Sonde zur
Messung von mechanischen Spannungen.

Es ist üblich, mechanische Spannungen zum Beispiel mittels Dehnungsmeßstreifen oder piezoelektrischer Kristalle zu messen. Derartige Anordnungen sind jedoch nicht in
ein Halbleiterchip integrierbar, weshalb sie auch nur
für gewisse Bereiche anwendbar sind und bei der fortschreitenden Entwicklung von Integrierten Schaltungen
nicht in allen erforderlichen technischen Sektoren anwendbar sind.

Aus "Zeitschrift für angewandte Physik", 17. Band,
7. Heft, 1964, Seiten 511 bis 517 sind Piezowiderstandseffekte von Silicium bekannt, und es wird dort eine Siliciummembran mit eindiffundierter Widerstandsbrücke aus
Dehnungsmeßstreifen zur Messung von mechanischen Span-

Kus 1 Dx / 13.08.1979

nungen beschrieben. Diese Membran ist jedoch wegen ihrer Größe und ihrer Dotierung nicht mit einem Verstärker in ein Halbleiterchip integrierbar.

Bei der Messung von mechanischen Spannungen mittels einer solchen Siliciummembran müssen die elektrischen Ausgangssignale verstärkt werden. Dazu sind Verbindungsleitungen zwischen der Siliciummembran und dem Verstärker nötig, die wegen der Einwirkung äußerer Felder eine gewisse Störempfindlichkeit der Meßsignale verursachen. Weiterhin weisen die Ausgangssignale einer solchen Siliciummembran eine durchaus nicht zu vernachlässigende Temperaturabhängigkeit auf. Diese Temperaturabhängigkeit ist eine weitere Fehlerquelle für hiernach erhaltene Meßergebnisse.

Aufgabe der vorliegenden Erfindung ist es daher, eine piezoresistive Sonde zur Messung von mechanischen Spannungen anzugeben, die möglichst unempfindlich ist gegen äußere Störeinflüsse und bei der sich die Temperaturabhängigkeit geeignet kompensieren läßt.

Diese Aufgabe wird dadurch gelöst, daß die piezoresistive Sonde in einer Integrierten Schaltung in ein Halbleiterchip so angebracht ist, daß im gleichen Halbleiterchip ein zugehöriger Verstärker integriert ist.

Mittels dieser Maßnahme entfallen entsprechende Verbindungsleitungen zwischen piezoresistiver Sonde und Verstärker, weshalb die Störempfindlichkeit einer solchen Sonde in vorteilhafter Weise herabgesetzt wird. Weiterhin kann die Temperaturabhängigkeit einer solchen Sonde bestimmt werden, und der Verstärker kann gleichzeitig so ausgelegt werden, daß er die Temperaturabhängigkeit der Sonde gerade kompensiert. Da die Sonde und der Verstärker innerhalb eines Halbleiterchips integriert sind, ist die Temperaturgleichheit beider Bauteile stets gegeben, weshalb die einmal eingestellte Temperaturkompensation stets funktioniert.

Es ist vorteilhaft, daß der Halbleiterchip aus Silicium besteht. Silicium eignet sich besonders zur Herstellung von piezoresistiven Sonden, da bei der Beachtung gewisser ausgewählter Kristallrichtungen eine gute Linearität zwischen dem erhaltenen elektrischen Ausgangssignal und der einwirkenden mechanischen Spannung besteht. Abgesehen davon sind für Silicium bezüglich seiner Herstellung und Verarbeitung eine Vielzahl von erprobten Technologien bekannt, die besondere Vorteile zur Herstellung von piezoresistiven Sonden bieten.

Es ist auch vorteilhaft, daß das Halbleiterchip aus einem Siliciumsubstrat eines ersten Leitfähigkeitstyps besteht, auf das eine Siliciumschicht eines zweiten, dem ersten Leitfähigkeitstyp entgegengesetzten Leitfähigkeitstyp epitaktisch auf das Siliciumsubstrat aufgebracht ist und in dieser epitaktisch aufgebrachten Siliciumschicht ein oder mehrere Widerstände sowie Spannungsanschlüsse und Spannungsabgriffe eingebracht sind.

Weiterhin ist es vorteilhaft, daß das Siliciumsubstrat p-dotiert und die epitaktische Siliciumschicht n-dotiert ist.

Mit der letztgenannten Maßnahme läßt sich besonders problemlos und technisch vorteilhaft eine piezoresistive Sonde neben zugehörigem Verstärker in einem Halbleiterchip integrieren.

Schließlich ist es vorteilhaft, daß die Lage der einzelnen Teile der Integrierten Schaltung im Halbleiterchip zueinander sowie die Richtung der einwirkenden mechanischen Spannungen in bezug auf den Halbleiterchip so gewählt wird, daß die mechanische Spannung ein möglichst großes elektrisches Signal hervorruft, das zugleich innerhalb eines gewissen Bereichs linear mit der zu messenden physikalischen Größe ist.

Da bekanntlich in Kristallen durch die verschiedenen Kristallrichtungen bestimmte Vorzugsrichtungen vorgegeben sind, ist es sehr wichtig, in welcher Richtung mechanische Spannungen auf einen Halbleiterkristall einwirken und in welcher Richtung und Anordnung darin befindliche Widerstände sowie Anschlüsse zur Stromversorgung und zum Spannungsabgriff angebracht sind, um einen maximalen Effekt zu erzielen und zugleich eine Linearität zwischen physikalischer Meßgröße und Meßsignal zu erreichen.

Nachfolgend wird die Erfindung an Hand der Zeichnung und an Ausführungsbeispielen näher erläutert:

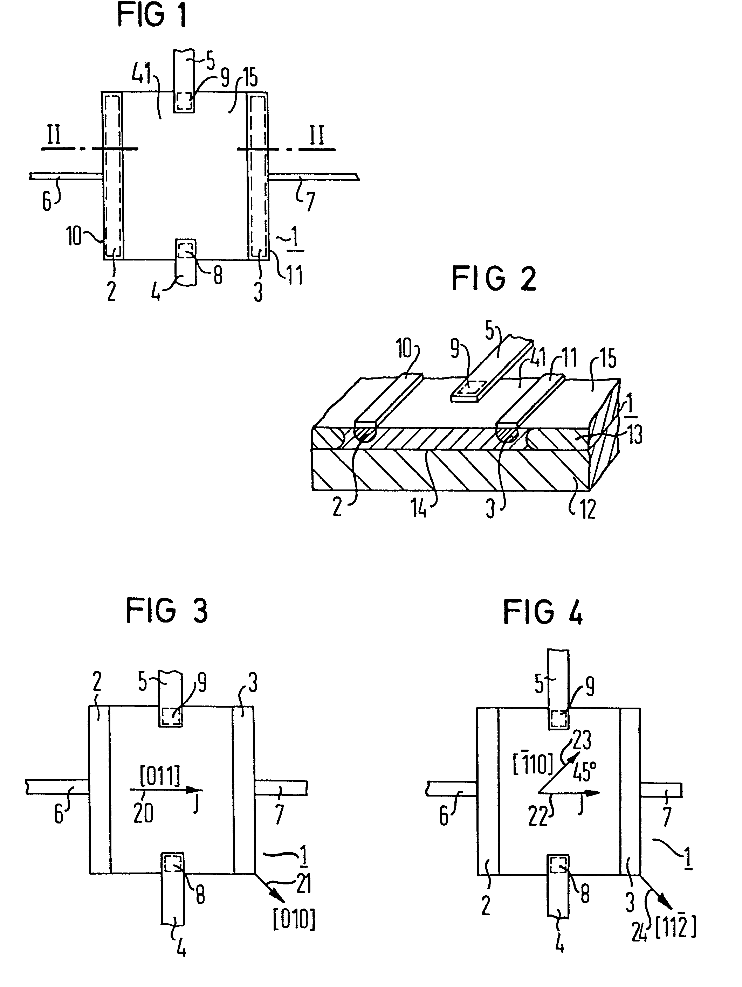

In den Fig. 1 bis 8 werden spezielle Ausführungsformen für erfindungsgemäße piezoresistive Sonden dargestellt, die insbesondere in Siliciumchips integriert werden können. Aus Gründen der Übersichtlichkeit sind hingegen im gleichen Chip befindliche Verstärker nicht dargestellt, zumal die Integration von Verstärkern in Halbleiterchips hinreichend bekannt ist.

Es zeigen:

Fig. 1      eine Draufsicht auf eine piezoresistive Sonde mit streifenförmigen Spannungsanschlüssen,

Fig. 2                  eine perspektivische Darstellung einer
                        längs der Linie II-II geschnittenen
                        Sonde nach Fig. 1,

Fig. 3 und Fig. 4 eine Draufsicht auf eine Sonde, nach
                        Fig. 1 mit Angabe von Strom-, Verformungs- und Kristallrichtung,

Fig. 5                  eine Draufsicht auf eine piezoresisti-
                        ve Sonde mit einer Widerstandsanord-
                        nung in Form einer Wheatstone-Brücke,

Fig. 6                  eine perspektivische Darstellung einer
                        längs der Schnittlinie III-III geschnittenen Sonde nach Fig. 5,

Fig. 7 und Fig. 8 eine Draufsicht auf eine Sonde nach
                        Fig. 5 mit Angabe von Strom-, Verformungs- und Kristallrichtung.

Fig. 1 stellt eine Draufsicht auf eine erfindungsgemäße piezoresistive Sonde 1 dar, auf der flache $n^{+}$-dotierte, streifenförmige Bereiche 2, 3, angedeutet durch die strichlierten Linien, unterhalb der Kontakte 10, 11 von der Halbleiteroberfläche 15 her in die epitaktisch aufgebrachte Halbleiterschicht eingebracht sind. Entsprechend sind $n^{+}$-dotierte Bereiche 8, 9, angedeutet durch die strichlierten Linien, unterhalb der Kontakte 4, 5 angebracht. Die Kontakte 10, 11 sind mit Spannungszuleitungen 6, 7 verbunden. Die strichpunktierte Linie II-II stellt eine Schnittlinie dar, längs der eine Sonde nach Fig. 1 senkrecht zur Zeichenebene geschnitten wird. Eine perspektivische Darstellung dieser Schnittfigur ist in Fig. 2 gezeichnet.
In den Fig. 2 bis 8 werden gleiche Teile aus Fig. 1 mit gleichen Ziffern belegt.

In Fig. 2 ist auf einem zum Beispiel p-dotierten Halbleitersubstrat 12 eine zum Beispiel n-leitende epitaktisch aufgebrachte Halbleiterschicht 13 abgeschieden. In diese Schicht 13 wird außerhalb der Widerstandsfläche 41 eine p-Dotierung eingebracht. Die $n^+$-dotierten, streifenförmigen Bereiche 2, 3, sowie die $n^+$-dotierten Bereiche 8, 9, angedeutet durch die strichlierten Linien, sind mit Kontakten 10, 11, 4, 5, zum Beispiel bestehend aus Aluminium, versehen. Die $n^+$-dotierten Bereiche 10, 11, 4, 5 verbessern die Güte der Kontakte. Auf der Oberfläche 15 der epitaktisch aufgebrachten Halbleiterschicht 13 ist ganzflächig mit Ausnahme der Kontaktanschlußbereiche eine, in der Zeichnung nicht dargestellte, Siliciumdioxidschicht zur Isolation und zum Schutze der Halbleiteroberfläche angebracht. Es ist nicht zwingend, ein p-dotiertes Halbleitersubstrat, zum Beispiel Siliciumsubstrat, mit n-dotierter epitaktisch aufgebrachter Siliciumschicht und n-dotierten Widerständen zu verwenden. Eine entsprechende Anordnung läßt sich auch mit anderem Halbleitermaterial sowie mit spiegelbildlichen Dotierungen der einzelnen Schichten erzielen.

In Fig. 3 und Fig. 4 sind piezoresistive Sonden 1 wie in Fig. 1 in der Draufsicht dargestellt, wobei durch Einzeichnen von Strom-, Verformungs- und Kristallrichtungen mittels der Pfeile 20 bis 24 besonders günstige Ausführungsbeispiele für Siliciumkristalle gegeben werden. In Fig. 3 sind die $n^+$-dotierten, streifenförmigen Bereiche 2, 3 so in der Siliciumschicht 13 angeordnet, daß der Strom J, angedeutet durch den Pfeil 20, in Richtung der $[01\bar{1}]$-Kristallrichtung fließt, während zu messende Drücke, Kräfte oder Beschleunigungen so auf die Siliciumschicht 13 einwirken sollen, daß die dadurch hervorgerufene mechanische Spannung, angedeutet durch den Pfeil 21, in der Kristallrichtung $[010]$ erfolgt.

In Fig. 4 sind die $n^+$-dotierten, streifenförmigen Bereiche 2, 3 so in der Siliciumschicht 13 angeordnet, daß der Strom J, angedeutet durch den Pfeil 22 unter einem Winkel von 45° zur Richtung der $[\bar{1}10]$-Kristallachse, angedeutet durch den Pfeil 23, fließt, während zu messende Drucke, Kräfte oder Beschleunigungen so auf die Siliciumschicht 13 einwirken sollen, daß dadurch hervorgerufene Spannungen, angedeutet durch den Pfeil 24, in der Kristallrichtung $[11\bar{2}]$ erfolgen.

Mit Ausführungsbeispielen nach Fig. 3 und Fig. 4 sind Sonden von annähernd optimaler Wirkungsweise zu erzielen, die innerhalb eines gewissen Meßbereichs eine annähernde Linearität von zu messender physikalischer Größe und angezeigter Spannung liefern.

Die Erfindung beschränkt sich jedoch nicht auf diese Ausführungsbeispiele allein. Jede in Fig. 3 und 4 angegebene Kristallrichtung ist bei gleicher Güte der Sonde zumindest mit jeder äquivalenten Kristallrichtung vertauschbar. Bei kubisch flächenzentrierten Kristallgittern, wie das das Gitter des Siliciumkristalls ist, sind äquivalente Kristallrichtungen alle jene Kristallrichtungen, deren physikalische Eigenschaften gleich sind. Äquivalente Kristallrichtungen lassen sich in einem kubisch flächenzentrierten Gitter durch Drehung oder Spiegelung ineinander überführen.

Die Fig. 5 gibt eine Draufsicht auf eine piezoresistive Sonde 1 mit einer Widerstandsanordnung in Form einer Wheatstone-Brücke. Auf einem zum Beispiel n-dotierten Siliciumrahmen 29 sind Kontakte 30, 31, 32, 33 auf $n^+$-dotierten Bereichen 24, 25, 26, 27, angedeutet durch strichlierte Linien, aufgebracht. Die Kontakte 30, 31, 32, 33 bestehen zum Beispiel aus Aluminium. An zwei

0024035

diagonal gegenüberliegenden Kontakten wird eine geeignete Betriebsspannung angelegt, während an den beiden anderen diagonal gegenüberliegenden Kontakten eine Spannung abgegriffen wird, die sich bei Einwirkung von mechanischen Spannungen auf die piezoresistive Sonde ändert. Die Spannungsänderung ist ein Maß für die mechanische Spannung an der Sonde. Die strichpunktierte Linie III-III in Fig. 5 gibt die Schnittlinie, längs welcher eine Sonde 1 nach Fig. 5 senkrecht zur Zeichenebene geschnitten wird. Dieser Schnitt wird in Fig. 6 perspektivisch dargestellt.

Fig. 6 zeigt ein zum Beispiel p-dotiertes Siliciumsubstrat 12, auf welches eine n-dotierte, epitaktisch aufgebrachte Halbleiterschicht 13 abgeschieden wurde. In die epitaktisch aufgebrachte n-leitende Siliciumschicht 13 wird außerhalb des Rahmens 29 eine ganzflächige p-Dotierung eingebracht. In den Rahmen 29 werden an den Ekken unterhalb der Kontakte 30, 31, 32, 33 $n^+$-dotierte Bereiche 25, 26, 27, 28, in der Zeichnung strichliert dargestellt, eingebracht. Die $n^+$-dotierten Bereiche bewirken eine bessere Kontaktierung zwischen dem darunterliegenden n-dotierten Silicium und den Kontakten 30, 31, 32, 33. Auf der Oberfläche 15 der epitaktisch aufgebrachten Halbleiterschicht 13 ist ganzflächig mit Ausnahme der Kontaktanschlußbereiche eine, in der Zeichnung nicht dargestellte, Siliciumdioxidschicht zur Isolation und zum Schutze der Halbleiteroberfläche abgeschieden.

Die Fig. 7 und 8 stellen eine Draufsicht der erfindungsgemäßen Sonde 1 nach Fig. 5 dar, wobei zusätzlich, bezogen auf die Kristallrichtungen, besonders günstige Stromrichtungen sowie Richtungen von mechanischen Spannungen angegeben werden, die durch die zu messenden Größen verursacht werden. In Fig. 7 sind die beiden Strom-

richtungen $I_1$ in Richtung der Kristallrichtung $[\overline{11}2]$, dargestellt durch den Pfeil 34, und $I_2$ in Kristallrichtung $[\overline{1}10]$, dargestellt durch den Pfeil 35, eingetragen, während die Richtung der durch die Meßgröße erzeugten mechanischen Spannung in Richtung der Kristallrichtung $[\overline{1}10]$, dargestellt durch den Pfeil 36, erfolgt.

In Fig. 8 ist die Stromrichtung $I_1$ in Richtung der Kristallachse $[001]$, dargestellt durch den Pfeil 38, vorgesehen, während die Stromrichtung $I_2$ parallel zur Kristallachse $[010]$ verläuft, dargestellt durch den Pfeil 37, und während gleichzeitig die durch die Meßgröße hervorgerufene mechanische Spannung in Richtung der $[010]$-Achse, dargestellt durch den Pfeil 39, verläuft.

Wie bereits vorn gesagt, lassen sich die in den Fig. 7 und 8 dargestellten Richtungen der Ströme und der mechanischen Spannungen durch alle im Kristall möglichen äquivalenten Kristallrichtungen unter Beibehaltung der gleichen physikalischen Bedingungen ersetzen.
Auch das Halbleitermaterial Silicium läßt sich durch ein geeignetes anderes Halbleitermaterial ersetzen. Die speziell gewählten Dotierungen können insbesondere zum Beispiel bezüglich n- und p- vertauscht eingebracht werden.

Im Falle eines Ausführungsbeispiels nach Fig. 5 bis 8 ist das Ersatzschaltbild eine Wheatstone-Brücke. Wird an zwei diagonal gegenüberliegenden Kontakten eine entsprechende Spannung angelegt, so läßt sich an den beiden anderen diagonal gegenüberliegenden Kontakten eine Spannung abgreifen, die sich bei Krafteinwirkungen auf das Siliciumchip infolge des Piezowiderstandeffekts ändert. Die resultierende Spannungsänderung kann somit als Maß für eine am Kristall anliegende mechanische Spannung dienen. Die Größe der Widerstandsänderung hängt hierbei von der Richtung der Siliciumkristallachsen und der Größe und der Richtung der mechanischen Spannung bezüglich der Stromrichtung ab. Für bestimmte Anordnungen dieser drei Richtungen und bestimmte Formen der Widerstandsbrücke ist die an der Widerstandsbrücke gemessene elektrische Spannung proportional, zum Beispiel zur Kraft auf das Siliciumchip, und kann mit Hilfe einer im gleichen Siliciumchip integrierten Verstärkerschaltung ausgewertet werden. Bei Ausführungsbeispielen nach den Fig. 1 bis 4 bewirken ebenfalls mechanische Spannungen im Kristall, die durch einwirkende Druck-, Kraft- oder Beschleunigungsänderungen hervorgerufen werden, eine entsprechende Spannungsänderung an den Kontakten 4, 5, wenn gleichzeitig eine geeignete Betriebsspannung an Spannungszuleitungen 6, 7 anliegt. Mit erfindungsgemäßen Sonden lassen sich Kräfte, Drucke und Beschleunigungen messen, die im Siliciumchip eine entsprechende mechanische Spannung hervorrufen.

Mit den erfindungsgemäßen Sonden lassen sich Drucksensoren und Beschleunigungssensoren sowie Kraftsensoren in Form von Integrierten Schaltungen herstellen.

8 Figuren
5 Patentansprüche

Patentansprüche

1. Piezoresistive Sonde (1) zur Messung von mechanischen Spannungen, d a d u r c h   g e k e n n z e i c h n e t, daß die piezoresistive Sonde (1) in einer integrierten Schaltung in einem Halbleiterchip so angebracht ist, daß im gleichen Halbleiterchip ein zugehöriger Verstärker integriert ist.

2. Piezoresistive Sonde (1) nach Anspruch 1, d a d u r c h   g e k e n n z e i c h n e t,   daß der Halbleiterchip aus Silicium besteht.

3. Piezoresistive Sonde (1) nach den Ansprüchen 1 und 2, d a d u r c h   g e k e n n z e i c h n e t,   daß das Halbleiterchip aus einem Siliciumsubstrat eines ersten Leitfähigkeitstyps besteht, auf das eine Siliciumschicht eines zweiten, dem ersten Leitfähigkeitstyp entgegengesetzten Leitfähigkeitstyp epitaktisch auf das Siliciumsubstrat aufgebracht ist und in dieser epitaktisch aufgebrachten Siliciumschicht ein oder mehrere Widerstände sowie Spannungsanschlüsse und Spannungsabgriffe eingebracht sind.

4. Piezoresistive Sonde (1) nach Anspruch 3, d a d u r c h   g e k e n n z e i c h n e t,   daß das Siliciumsubstrat (12) p-dotiert und die epitaktische Siliciumschicht (13) n-dotiert ist.

5. Piezoresistive Sonde (1) nach mindestens einem der Ansprüche 1 bis 4, d a d u r c h   g e k e n n z e i c h ﹣ n e t,   daß die Lage der einzelnen Teile der integrierten Schaltung im Halbleiterchip zueinander sowie die Richtung der einwirkenden mechanischen Spannungen in bezug auf den Halbleiterchip so gewählt wird, daß die mechanische Spannung ein möglichst großes elektrisches Signal hervorruft, das zugleich innerhalb eines gewissen
Bereichs linear mit der zu messenden physikalischen
Größe ist.

1/2

FIG 1

FIG 2

FIG 3

FIG 4

2/2

## FIG 5

## FIG 6

## FIG 7

## FIG 8

**Europäisches Patentamt**

# EUROPÄISCHER RECHERCHENBERICHT

| | EINSCHLÄGIGE DOKUMENTE | | KLASSIFIKATION DER ANMELDUNG (Int. Cl. ³) |
|---|---|---|---|
| Kategorie | Kennzeichnung des Dokuments mit Angabe, soweit erforderlich, der maßgeblichen Teile | betrifft Anspruch | |
| X | GB - A - 1 278 210 (FERRANTI LTD.) <br> * Ansprüche 1,2; Seite 2, Zeilen 15-41, 92-97, 108-123; Figuren 1-4 * <br><br> -- | 1-5 | H 01 L 27/20 <br> G 01 L 1/22 |
| X | US - A - 3 808 473 (MATSUSHITA ELECTRIC INDUSTRIAL CO., LTD.) <br> * Spalte 2, Zeilen 13-38; Spalte 3, Zeilen 32-64; Figur 5 * <br><br> -- | 1,2 | |
| X | IEEE TRANSACTIONS ON ELECTRON DE-VICES, Band ED-16, Nr. 10, Oktober 1969, Seiten 867-870 <br> New York, U.S.A. <br> D.E. FULKERSON: "A Silicon Inte-grated Circuit Force Sensor" <br> * Seite 867, Spalte 1, Abschnitt 1; Seite 869, Spalte 1, Ab-schnitt 1; Figuren 3-5 * <br><br> -- | 1,2,5 | RECHERCHIERTE SACHGEBIETE (Int. Cl. ³) <br><br> H 01 L 27/20 |
| X | IEEE INTERNATIONAL SOLID STATE CIR-CUITS CONFERENCE, Band 22, Februar 1979, Seiten 196-197 <br> New York, U.S.A. <br> J.M. BORKY et al.: "Integrated Sig-nal Conditioning for Diaphragm Pressure Sensors" <br> * Seite 196, Spalte 1, Abschnitte 1-3; Seite 197; Figuren 1,2 * <br><br> -- | 1,2 | |
| X | US - A - 3 899 695 (NATIONAL SEMI-CONDUCTOR CORPORATION) <br> * Anspruch 1; Spalte 1, Zeilen 65-68; Spalte 2, Zeilen 1-15; 46-61; Spalte 3, | 1,2 | KATEGORIE DER GENANNTEN DOKUMENTE <br><br> X: von besonderer Bedeutung <br> A: technologischer Hintergrund <br> O: nichtschriftliche Offenbarung <br> P: Zwischenliteratur <br> T: der Erfindung zugrunde liegende Theorien oder Grundsätze <br> E: kollidierende Anmeldung <br> D: in der Anmeldung angeführtes Dokument <br> L: aus andern Gründen angeführtes Dokument <br> &: Mitglied der gleichen Patent-familie, übereinstimmendes Dokument |

Der vorliegende Recherchenbericht wurde für alle Patentansprüche erstellt.

| Recherchenort | Abschlußdatum der Recherche | Prüfer |
|---|---|---|
| Den Haag | 05-11-1980 | MIOT |

| | EINSCHLÄGIGE DOKUMENTE | | KLASSIFIKATION DER ANMELDUNG (Int. Cl.³) |
|---|---|---|---|
| Kategorie | Kennzeichnung des Dokuments mit Angabe, soweit erforderlich, der Maßgeblichen Teile | betrifft Anspruch | |
| | Zeilen 29-59; Figuren 1-5 * <br><br> -- <br><br> IBM TECHNICAL DISCLOSURE BULLETIN, Band 17, Nr. 8, Januar 1975, Seiten 2439-2440 <br> New York, U.S.A. <br> W.E. SCHILLINGER: "Integrated High-Precision Transducer" <br><br> * Seite 2439, Abschnitt 4 * <br><br> ---- | 1,2 | |

RECHERCHIERTE SACHGEBIETE (Int. Cl.³)